# EUROPEAN PATENT APPLICATION

(11) **EP 4 456 689 A1**
(43) Date of publication of application: **30.10.2024**
(21) Application number: 23170818.1
(22) Date of filing: 28.04.2023
(51) Int. Cl.: H05K 7/20, H05K 7/18, H05K 5/00

(54) **A COOLING RACK FOR AN ELECTRONIC UNIT**

(71) Applicant: Aptiv Technologies AG, 8200 Schaffhausen (CH)
(72) Inventor: BARUS, Lukasz, DUBLIN 2 (IE); SWIERCZ, Karol, DUBLIN 2 (IE); OBRATANSKI, Jan, DUBLIN 2 (IE); TYNIEC, Maciej, DUBLIN 2 (IE)
(74) Representative: Lewis Silkin LLP

(57) **Abstract**

A cooling rack (10) for a plurality of electronic units (14). The cooling rack is primarily embodied by a mounting device (12) that removably docks the electronic units (14) so that a single, common cooling plate (20) is in thermal contact with multiple electronic units to simultaneously dissipate heat from electronic components within each unit. An ECU is also described which comprises internal thermal bridges (24) between with components therein and an interface surface, e.g. a rear wall, that thermally contacts the cooling plate.

## Description

### Introduction

The present disclosure relates to a cooling rack or system of cooling for an electronics unit. The present disclosure is particularly relevant to an electronics unit used in vehicles.

### Background

Electronics units have become an integral part of our daily lives, and they are used in various applications such as personal computers, servers, and data centers. As electronic devices become more complex and powerful, they generate more heat, which can lead to reduced performance, increased power consumption, and even device failure. To overcome these challenges, cooling systems are used to dissipate the heat generated by the electrical components.

One common approach to cooling electronic devices is air cooling, which involves using fans or other airflow mechanisms to move air over one or more heat sinks that are in contact with the electronic components. This method is relatively simple and inexpensive, but it has limitations in terms of its ability to dissipate large amounts of heat. Another approach is liquid cooling, which involves circulating a liquid coolant, e.g., water, through channels or pipes that are in contact with the electronic component. Liquid cooling can be more effective than air cooling, but it is typically more complex and expensive to implement.

In recent years, there has been growing demand for high-density electronic systems that can handle large amounts of data processing and storage. This has led to the development of high-power electronic units based on high-power System in Package (SIP) architecture, which can generate a significant amount of heat. These units require sophisticated cooling solutions to ensure proper operation and prevent overheating.

Existing cooling systems for electronic clusters involve the use of complex water-cooling systems, which can be expensive and difficult to maintain. These systems require specialised equipment and plumbing and can be prone to leaks or other issues. In addition, these systems are often not well-suited to high-density electronic systems, as they require a significant amount of space and can be difficult to integrate into a rack or other enclosure.

Accordingly, there is a need to provide a more efficient and effective cooling system for electronic clusters. Such a system should be able to dissipate large amounts of heat generated by high-power electronic units, while being simple and cost-effective to implement.

### Summary

In light of the above, the present invention seeks to provide a simple and cost-effective solution for cooling high-density electronic systems.

Broadly, a cooling rack is disclosed according to claim 1. Particularly, the use of a common cooling plate coupled to the side of a rack mount/docking station structure eliminates the need for complex water-cooling systems, reducing both cost and maintenance requirements. Additionally, the design of the rack with a cooling backplate simplifies the solution and makes it a single responsibility system.

Advantageously, the cooling system herein is effective at dissipating heat generated by high-power electronic units. The cooling plate provides a large surface area for heat dissipation, and the thermal interfaces ensure efficient heat transfer between the electronic components and the cooling plate. This allows effective cooling of the entire system, preventing overheating and ensuring proper operation.

The cooling system is highly adaptable and can be easily integrated into existing electronic systems. The rack is designed to accommodate a variety of electronic units, and the cooling plate can be configured to fit a range of sizes and shapes.

According to one aspect of the invention, there is provided a cooling rack for an electronic unit comprising a mounting mechanism (e.g. device) configured to removably receive at least one electronic unit comprising at least one heating source element. The cooling system further comprising a cooling plate, which may be considered a common cooling plate, located at a side on the inside or outside of the mounting device. The cooling plate is configured to be in thermal contact with the at least one electronic unit to dissipate heat from the at least one heating source element. The rack may be supplied with one or more ECUs or such devices may be supplied separately, e.g. at different times during configuration of the system.

In this way, a single, common cooling plate can be in thermal contact with multiple electronic units to dissipate heat from at least one heating source element. The heating source element can be an integrated circuit component, or any other component that produced heat in operation. The mounting device, or docking device, can receive any electronic unit and electronic units can be removed or replaced in the mounting device.

In one form, the cooling system further comprises a thermal interface surface between the cooling plate and the electronic unit.

In one form, the thermal interface surface is a pad configured to interface between at least one thermal channel associated with the at least one heating source element and the cooling plate.

In one form, the mounting device comprising a rack configured to receive a plurality of electronic units. The cooling plate is configured to be in thermal contact with at least one electronic unit of the plurality of electronic units.

In one form, the rack comprises side walls and a plurality of dividing walls configured to form a plurality of walled cavities, each for receiving an electronic unit.

In one form, the rack comprises a plurality of fixing elements configured to receive and couple an electronic unit to the mounting device.

In one form, the rack is not a separate part form cooling plate, so cooling plate has fixing arms for units incorporated within itself.

In one form, the plurality of electronic units are arranged horizontally and/or vertically.

In one form, the plurality of electronic units are arranged around cooling plate/column.

In one form, the cooling plate is configured to receive a liquid coolant or air.

In one form, the cooling plate forms at least part of a wall of the mounting device.

In one form, the cooling plate forms a column or wall within the mounting device.

According to another aspect of the invention, there is provided an electronic unit for use in a system with the cooling rack. Broadly, an electronic unit may comprise at least one heating source element, a thermal interface surface for contacting the cooling plate, and at least one thermal bridge associated with the at least one heating source element. The thermal bridge for transferring heat between the at least one heating source element and the thermal interface.

In one form, the electronic unit further comprises a cover which incorporates the at least one thermal bridge. The at least one thermal bridge comprises a heat conductive material. The at least one heating source element is an integrated circuit or a system in package.

In one form, the electronic unit further comprises a housing configured for docking into the cooling system. The thermal interface surface for contacting the cooling plate is part of at least one wall of the housing.

In one form, the thermal interface surface is at least one pad configured to direct heat from the at least one thermal bridge to the cooling plate.

According to another aspect of the invention, there is provided a method of arranging a cooling rack with ECUs. Broadly, a method of arranging a cooling system, the method comprising providing a cooling system and docking, into the cooling system, at least one electronic unit.

The invention is applicable not only to automotive applications, but to any field where electrical units require cooling.

### Brief Description of Drawings

Illustrative embodiments will now be described with reference to the accompanying drawings in which:
Figure 1 illustrates a perspective overview of a cooling system and an electronic unit according to one aspect of the present disclosure;
Figure 2 illustrates a cross-sectional view of cooling system and an electronic unit according to one aspect of the present disclosure;
Figure 3 illustrates a perspective overview of an electronic unit according to one aspect of the present disclosure; and
Figure 4 illustrates an exploded view of a cooling system and an electronic unit according to one aspect of the present disclosure.

### Detailed Description

The following description presents exemplary embodiments and, together with the drawings, serves to explain principles of the invention. However, the scope of the invention is not intended to be limited to the precise details of the embodiments or exact adherence with all features and/or method steps of implementation, since variations will be apparent to a skilled person and are deemed also to be covered by the description. Terms for components used herein should be given a broad interpretation that also encompasses equivalent functions and features. In some cases, several alternative terms (synonyms) for structural features, sometimes separated by a "/", have been provided but such terms are interchangeable and not intended to be exhaustive. Descriptive terms should also be given the broadest possible interpretation; e.g. the term "comprising" as used in this specification means "consisting at least in part of" such that interpreting each statement in this specification that includes the term "comprising", features other than that, in addition to, or those prefaced by the term may also be present. Related terms such as "comprise" and "comprises" are to be interpreted in the same manner. Directional terms such as "vertical", "horizontal", "up", "down", "sideways", "upper" and "lower" are used for convenience of explanation usually with reference to the orientation shown in illustrations and are not intended to be ultimately limiting if an equivalent function can be achieved with an alternative dimension and/or direction. Therefore, all directional terms are merely relative to each other.

The description herein refers to embodiments with particular combinations of steps or features, however, it is envisaged that further combinations and cross-combinations of compatible steps or features between embodiments will be possible. Indeed, isolated features may function independently as an invention from other features and not necessarily require implementation as a complete combination.

It will be understood that the illustrated embodiments show applications only for the purposes of explanation. In practice, the invention may be applied to many different configurations, where the embodiment is straightforward for those skilled in the art to implement.

The present invention is directed to a cooling system for an electronic unit, particularly for use in a rack-based configuration with multiple electronic units. The cooling system is designed to efficiently dissipate heat generated by one or more heating source elements within the electronics unit. In addition, the cooling system described herein provides a more cost-effective solution to existing liquid cooling system, which will be described in more detail below.

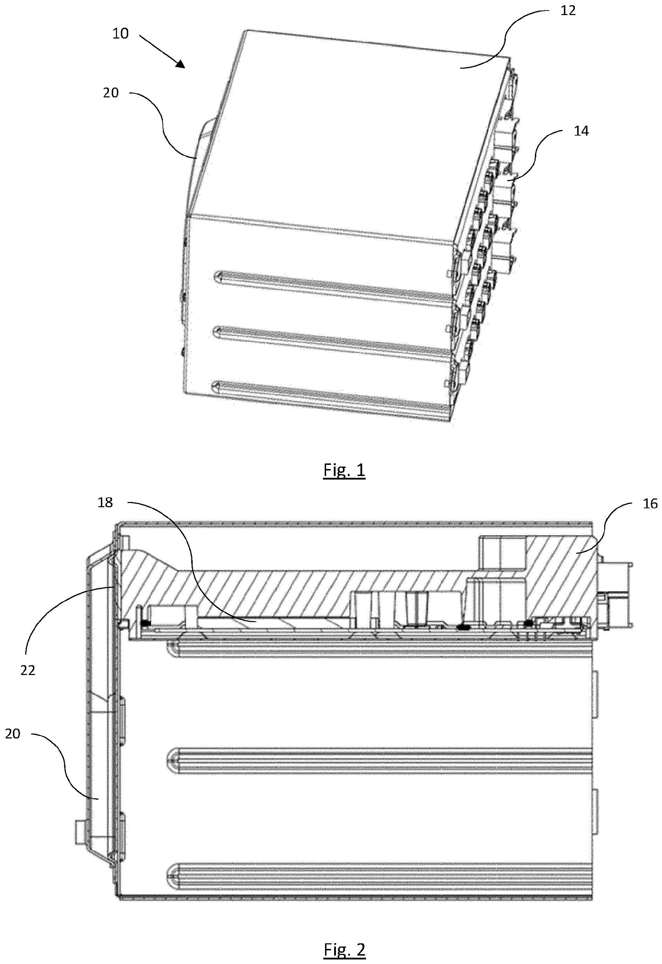

Figure 1 shows a cooling system 10 according to an embodiment of the present invention. The cooling system 10 comprises a docking device 12 and an electronic unit 14 mounted inside the docking device 12. The docking device 12 can be any shape or size to allow the electronic unit 14 to be docked or mounted inside. In one example, the docking device 12 and the electronic unit 14 are integrally formed.

The electronic unit 14 comprises a unit cover 16 and at least one heating source element 18. The unit cover 16 is in thermal contact with the heating source element 18. In the illustrated form, the unit cover 16 can be considered to act as a heat sink to the heating source elements within the electronic unit 14.

The heating source element 18 may be an integrated circuit, or a System in Package (SIP), or any other electrical component. For example, the electronic unit 14 can contain a printed circuit board supporting at least one integrated circuit and/or other electrical components.

A cooling plate 20 is coupled to a side/back of the docking/mounting device 12. The cooling plate 20 can be coupled to the inside of the mounting device 12 to forms separate columns and/or walls inside of mounting device 12. The cooling plate 20 can be coupled to electronic units 14 with unconventional shapes. For example, the cooling plate 20 can be coupled to electronic units 14 having a U-shape, or any other shape, comprising undercuts in unit cover 16, or heatsink. As such, the cooling plate 20 can be coupled to the back of the docking device 12, or to any other side, or any side within the inside the docking device 12, or to form a wall or column within the docking device 12.

The cooling plate 20 is in thermal contact with the unit cover 16 and is configured to dissipate heat from the heating source element 18. The cooling plate 20 may be configured to receive a liquid coolant, such as water or other coolant fluid. Alternatively, the cooling plate may by configured to receive a gas as the cooling medium. The circulation of the fluid, or gas, through the cooling plate 20 enables the cooling plate to remain at a low temperature relative to the heating source elements 18. The cooling plate 20 being at a temperature lower than the temperature of the heating source element 18 is such that a thermal gradient is created to dissipate heat through forced convection. In one example, the cooling plate 20 is connected to the cooling loop of a host vehicle, such as a cooling loop of a car.

The cooling plate 20 and/or unit 14 may comprise a thermal pad 22 for each heating source element 18, or one common thermal pad for two and more heating source elements, or one common thermal pad for every heating source element in the unit, which is coupled to the cooling plate 20 between the cooling plate 20 and the unit cover 16. Alternatively, the cooling plate and/or unit 14 may not comprise a thermal pad 22. The thermal pad 22 may be a thermal interface material (TIM), or thermal grease, or any other suitable material. The thermal pad 22 reduces air gaps, which act as thermal insulation, between the cooling plate 20 and a surface of the unit 14 . This maximises heat transfer and dissipation at the contact area between the cooling plate 20 and the unit cover 16.

The unit cover 16 may comprise a thermal channel 24 for each heating source element 18, or may comprise a common thermal channel 24 for two or more heating source elements 18, or may comprise a common thermal channel 24 for all heating source elements 18. The thermal channel 24 configured to help to dissipate heat from the heating source element 18 to the cooling plate 20. In one example, if the that walls of unit cover 16 are sufficient to transfer heat from heating source elements 18 to the cooling plate 20, the thermal channel 24 may be not used. The thermal channel 24 may comprise a heat conductive material, such as aluminium, magnesium, zinc, or any other suitable material. The unit cover 16 and the thermal channel 24 can be of the same material, or different materials. The thermal channels 24 may be integrated with the cover 15, or as separate bridge components between a heat generating electronic component and a rear wall of the unit 14. The thermal channels 24 may each direct heat to a single thermal pad, which in turn interfaces with the cooling plate 20, or any other combination thereof, such as a thermal pad servicing more than one channel/component.

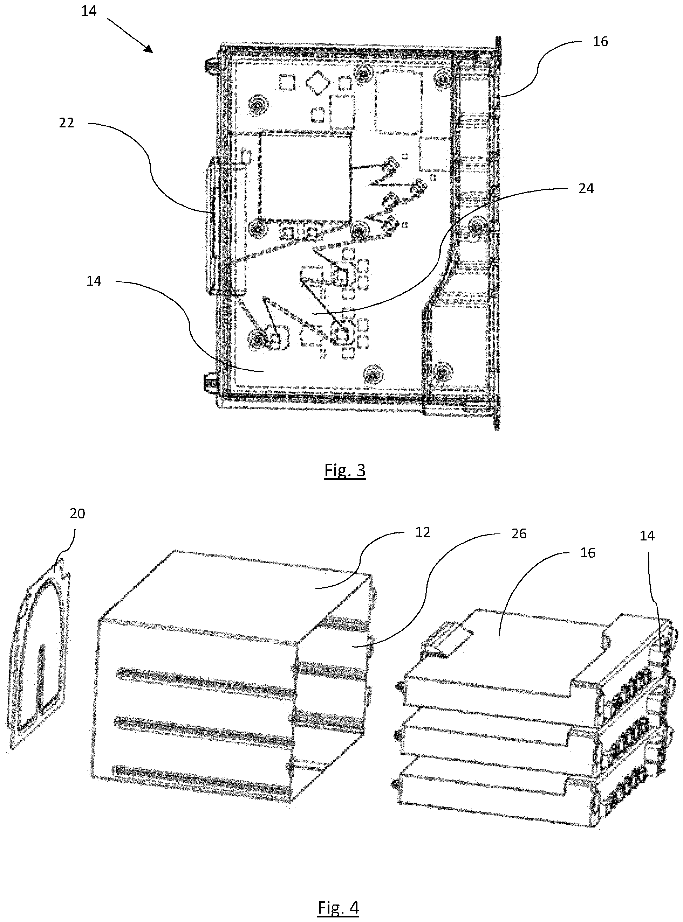

Referring to Figure 4, the docking device 12 may be a rack comprising a plurality of receptacles 26, each configured for containing an electronic unit 14. The docking device 12 may not contain any receptacles but have a fixing means incorporated to guide and secure every electronic unit 14 inside. The illustrated embodiment may also be considered a docking station or modular cooling station for ECUs that, in any event, utilise a common cooling plate. A rack containing multiple electronic units 14 is known as an electronic unit cluster. The receptacles 26 provide volumes/cavities/chambers in which the electronic units 10 can be mounted to the rack, and/or the receptacles 26 can be separated by a dividing wall to separate the electronic units 14. The receptacles 26 may be arranged horizontally and/or vertically. The receptacles 26 may be located around a common the cooling plate 20, or column, that is not on the side but placed inside of rack. The same positioning principles may be applied to a receptacle-less design with only fixing features for each unit instead. In a rack, each electronic unit 14 may be in thermal contact with the cooling plate 20, e.g. each by one or more thermal pads or a corresponding surface of an external wall, such as the rear wall. Alternatively, each electronic unit 14 may not be in thermal contact with the cooling plate 20 depending on the heat dissipation requirements of a particular electronic unit 14.

In one example of this disclosure, multiple electronic units 10, each having at least one heating source element 18, can be connected to a single cooling plate 20. Therefore, the cooling system provides a cost-effective solution to existing cooling systems that require an individual cooling source (air cooling or liquid cooling) to be connected to each electronic unit and/or for each individual or group of heating source element 18. Typically, in systems where each ECU and/or heating source element is connected to an individual cooling source, each may require maintenance for a potential leak. Therefore, having one cooling plate 20 for multiple electronic units 10 reduces the potential for a leak and corresponding maintenance time and cost.

In operation, each heating source element 18 generates heat when activated, which is dissipated through the unit cover 16 and/or via the thermal channel 24. The thermal channel 24 transfers the heat to the thermal pad 22 or rear wall structure, which then transfers the heat to the cooling plate 20. As mentioned, the thermal channel 24 can be integrally formed as part of the unit cover 16 or can be formed as one or more separate elements. The cooling plate 20 dissipates heat from the heating source element 18 through convection and/or conduction to the surrounding environment, and/or to a liquid coolant in the cooling plate 20. The liquid coolant can then be circulated through a liquid cooling system to, ultimately, dissipate the heat away from the electronic unit 10.

The cooling system of the present invention provides an efficient and effective means of dissipating heat from electronic units, especially in a rack or frame-based configuration with multiple electronic units. The use of thermal channels and a corresponding thermal interface at a wall of the ECU provides a direct thermal pathway from the heating source element to the cooling plate, improving heat dissipation. Additionally, the use of a liquid coolant in the cooling plate provides a highly efficient method of heat transfer, improving overall cooling performance.

The structure of the invention could be summarised as a mounting device for removably docking one or more electronic units so that a single cooling plate, or otherwise simplified coolant circuit, is in thermal contact with multiple electronic units to simultaneously dissipate heat from electronic components within each unit. An ECU is also described which comprises internal thermal bridges between with components therein and an interface surface, e.g. a rear wall, that thermally contacts the cooling plate.

Although an overview of the inventive subject matter has been described with reference to specific example embodiments, various modifications and changes may be made to these embodiments without departing from the broader scope defined by the appended claims.

Despite of description of a units cluster , it is possible to use a semi-passive cooling system only for one unit. As a result, the rack may be restricted only to one mounting slot to meet the thermal requirements. As such, excessive and expensive liquid cooling may not be applied to only one unit in rack making the assembly cheaper and more easily serviceable.

## Claims

1. A cooling rack, comprising:
at least one electronic unit, each comprising a plurality of electronic components;
a mounting mechanism configured to removably receive at least one electronic unit; and
a cooling plate configured to be in thermal contact with each of the electronic units to dissipate heat generated from the electronic components.

2. The cooling rack according to claim 1, further comprising:
a thermal interface surface between the cooling plate and the electronic unit.

3. The cooling rack according to claim 2, wherein the thermal interface surface is a pad provided on at least one of the electronic control units and configured to interface between at least one thermal channel associated with at least one of the plurality of electronic components and the cooling plate.

4. The cooling rack according to any preceding claim, the mounting mechanism comprising a carrier configured to slidably receive a plurality of electronic units, wherein the cooling plate is located on a side of and/or within the rack, configured to be in thermal contact with each of the plurality of electronic units.

5. The cooling rack according to claim 4, wherein the carrier comprises side walls and a plurality of dividing walls configured to form a plurality of walled cavities, each for receiving an electronic unit.

6. The cooling rack according to claim 4 or 5, wherein the carrier comprises a plurality of fixing elements configured to receive and couple an electronic unit to the rack.

7. The cooling rack according to any of claims 4 to 6, wherein the plurality of electronic units are arranged horizontally and/or vertically.

8. The cooling rack according to any of claims 4 to 7, wherein the plurality of electronic units are arranged around the cooling plate.

9. The cooling rack according to any preceding claim, wherein the cooling plate is configured to receive a liquid coolant or air.

10. The cooling rack according to any preceding claim, wherein the cooling plate forms at least part of a wall of the mounting device.

11. The cooling rack according to any of claims 4 to 10, wherein the cooling plate forms a column or wall within the mounting mechanism.

12. The cooling rack of claim 1, the electronic unit comprising:
a thermal interface surface for contacting the cooling plate;
at least one thermal bridge associated with the at least one heating source element, for transferring heat between at least one of the plurality of electronic components and the thermal interface.

13. The cooling rack according to claim 12, the electronic unit comprising a cover which incorporates the at least one thermal bridge.

14. The cooling rack according to claim 12 or 13, the electronic unit further comprising a housing configured for docking into the mounting mechanism, wherein the thermal interface surface for contacting the cooling plate is part of at least one wall of the housing.

15. A method of arranging electronic control units in a vehicle, the method comprising:
providing a cooling rack according to any one of claims 1 to 14; and
docking, into the cooling rack, at least one electronic unit to establish heat transfer between the plurality of electronic components and the cooling plate.
